# EUROPEAN PATENT APPLICATION

(11) **EP 4 851 639 A1**
(43) Date of publication of application: **09.12.2026**
(21) Application number: 25748301.6
(22) Date of filing: 23.01.2025
(51) Int. Cl.: G01R 1/067, G01R 1/073

(54) **PROBE AND ELECTRICAL CONNECTION DEVICE**

(30) Priority: 30.01.2024 JP 2024011689
(71) Applicant: Kabushiki Kaisha Nihon Micronics, Musashino-shi Tokyo 180-8508 (JP)
(72) Inventor: NASU, Mika, Musashino-shi, Tokyo 180-8508 (JP)
(74) Representative: Samson & Partner Patentanwälte mbB
(86) International application number: PCT/JP2025/002026
(87) International publication number: WO 2025/164493

(57) **Abstract**

A probe includes a structure in which a tip portion, a curved portion, and a base end portion are sequentially connected in an axial direction. In a cross section perpendicular to the axial direction, a first member and a second member having a lower hardness than the first member are mixed. The curved portion includes a low-hardness portion in which an area ratio of the second member to the first member in the cross section is relatively higher than in other regions. An area of the cross section is constant from the tip portion to the base end portion.

## Description

### TECHNICAL FIELD

The present invention relates to a probe and an electrical connection device used for inspecting electrical characteristics of an inspection target.

### BACKGROUND ART

An electrical connection device including a probe is used to inspect electrical characteristics of an inspection target, such as a semiconductor integrated circuit, in a wafer state. In the inspection using a probe, one end of the probe is brought into contact with an electrode pad of the inspection target, and the other end of the probe is brought into contact with a terminal (hereinafter referred to as a "land") disposed on a printed circuit board or the like. The land is electrically connected to an inspection device such as a tester.

In the inspection of an inspection target, after the probe is brought into contact with the electrode pad, a process (hereinafter also referred to as "overdrive") is performed in which the electrical connection device and the inspection target are further brought closer to each other to curve the probe by elastic deformation. By curving the probe through overdrive, the probe can be stably brought into contact with the electrode pad and the land by the elastic force of the probe.

### CITATION LIST

### Patent Literature

Patent Literature 1: Japanese Patent Application Publication No. 2018-91870

### SUMMARY

### PROBLEMS TO BE SOLVED

In order to curve a probe, a probe that is partially formed with a reduced-diameter portion (hereinafter also referred to as a "constriction") having a narrower diameter than other portions is used. However, the constricted portion of the probe has a smaller cross-sectional area. For this reason, when a constriction is formed in the probe, the magnitude of current that can flow through the probe (hereinafter also referred to as "allowable current value") decreases. An object of the present invention is to provide a probe having a structure that is easy to curve without decreasing the allowable current value and an electrical connection device.

### SOLUTION TO SOLVE PROBLEMS

A probe according to an aspect of the present invention includes a structure in which a tip portion to be brought into contact with the inspection target, a curved portion, and a base end portion are sequentially connected in an axial direction. A first member and a second member having a lower hardness than the first member are mixed in a cross section perpendicular to the axial direction. The curved portion includes a low-hardness portion in which an area ratio of the second member to the first member in the cross section is relatively higher than in other regions. An area of the cross section is constant from the tip portion to the base end portion.

### EFFECTS

According to the present invention, it is possible to provide a probe having a structure that is easy to curve without decreasing the allowable current value and an electrical connection device.

### BRIEF DESCRIPTION OF DRAWINGS

[FIG. 1] FIG. 1 is a schematic diagram illustrating a configuration of a probe according to an embodiment of the present invention.
[FIG. 2A] FIG. 2A is a schematic cross-sectional view taken along a IIA-IIA direction in FIG. 1.
[FIG. 2B] FIG. 2B is a schematic cross-sectional view taken along a IIB-IIB direction in FIG. 1.
[FIG. 2C] FIG. 2C is a schematic cross-sectional view taken along a IIC-IIC direction in FIG. 1.
[FIG. 3] FIG. 3 is a schematic diagram illustrating the probe of FIG. 1 that is disassembled.
[FIG. 4] FIG. 4 is a schematic diagram illustrating a configuration of an electrical connection device having a probe according to the embodiment of the present invention.
[FIG. 5A] FIG. 5A is a schematic diagram illustrating an example of a cross section of a probe according to a first modified example of the embodiment of the present invention.
[FIG. 5B] FIG. 5B is a schematic diagram illustrating another example of a cross section of the probe according to the first modified example of the embodiment of the present invention.
[FIG. 6A] FIG. 6A is a schematic diagram illustrating an example of a cross section of a probe according to a second modified example of the embodiment of the present invention.
[FIG. 6B] FIG. 6B is a schematic diagram illustrating another example of a cross section of the probe according to the second modified example of the embodiment of the present invention.
[FIG. 7] FIG. 7 is a schematic diagram illustrating an example of a cross section of a probe according to a third modified example of the embodiment of the present invention.
[FIG. 8] FIG. 8 is a schematic diagram illustrating an example of a cross section of a probe according to a fourth modified example of the embodiment of the present invention.

### DESCRIPTION OF EMBODIMENTS

Next, embodiments of the present invention will be described with reference to the drawings. In the following description of the drawings, the same or similar parts are denoted by the same or similar reference numerals. However, it should be noted that the drawings are schematic and that the ratios of thicknesses of the respective parts may differ from actual ones. It goes without saying that portions with different dimensional relationships and ratios from each other are also included among the drawings. The embodiments described below exemplify devices and methods for embodying the technical idea of the present invention, and the embodiments of the present invention do not specify the material, shape, structure, arrangement, manufacturing method, and the like of the constituent parts to those described below.

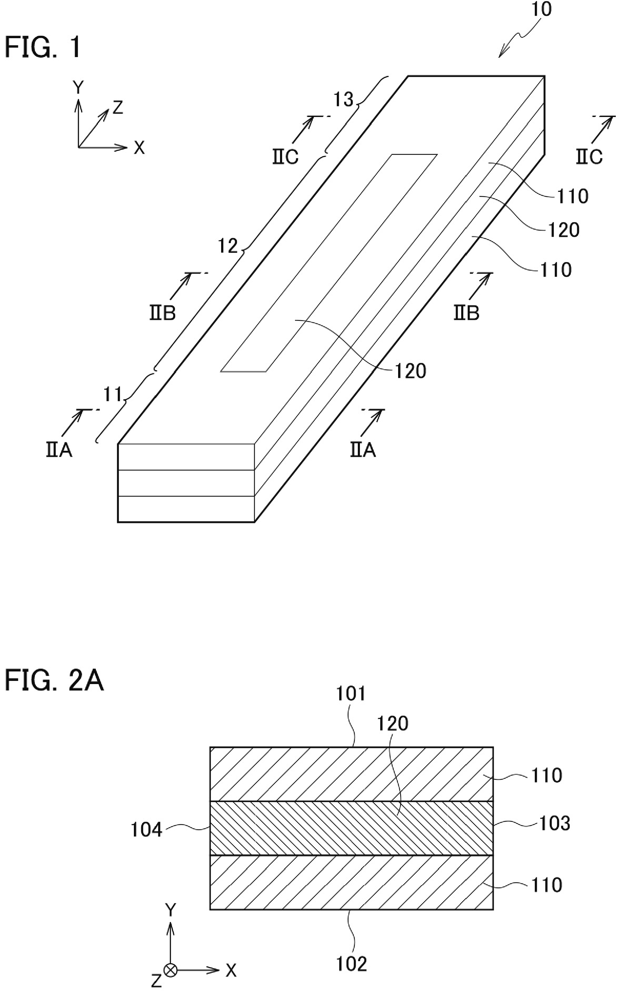

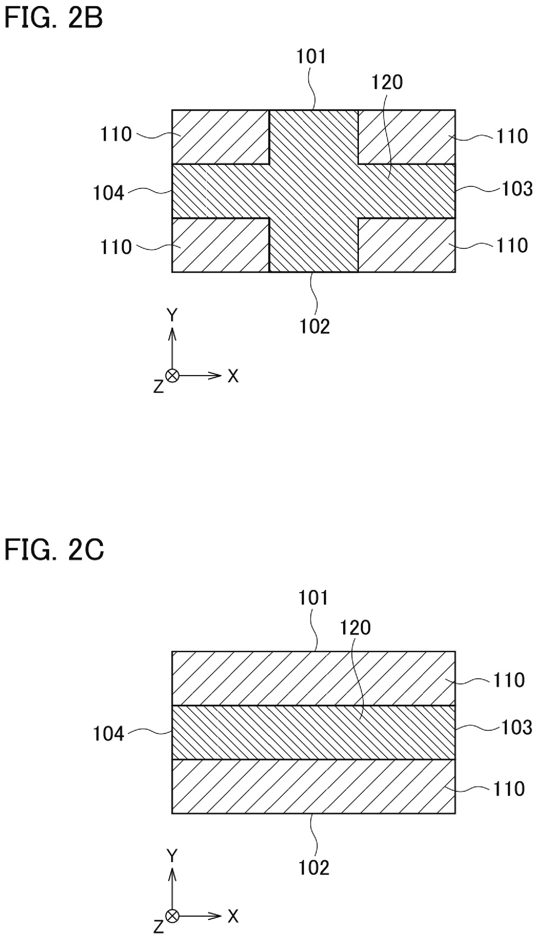

A probe 10 according to an embodiment illustrated in FIG. 1 is used for inspecting electrical characteristics of an inspection target. The probe 10 has a columnar shape including a structure in which a tip portion 11, a curved portion 12, and a base end portion 13 are sequentially connected in an axial direction. The tip portion 11 is brought into contact with the inspection target when the inspection target is inspected. FIG. 2A illustrates a cross-sectional view of the tip portion 11 of the probe 10 taken along a IIA-IIA direction. FIG. 2B illustrates a cross-sectional view of the curved portion 12 of the probe 10 taken along a IIB-IIB direction. FIG. 2C illustrates a cross-sectional view of the base end portion 13 of the probe 10 taken along a IIC-IIC direction.

As illustrated in FIGS. 2A to 2C, a first member 110 and a second member 120 are mixed in a cross section perpendicular to the axial direction (hereinafter simply referred to as the "cross section"). A material having a lower hardness than the first member 110 is used for the second member 120.

As illustrated in FIGS. 2A and 2C, the first members 110 and the second member 120 are laminated in the cross sections of the tip portion 11 and the base end portion 13. More specifically, the second member 120 is interposed between the first members 110. In regions of the probe 10 other than the curved portion 12, the second member 120 may be interposed between the first members 110 over a whole of the width direction.

As illustrated in FIG. 1, the axial direction in which the probe 10 extends is referred to as a Z direction, the thickness direction in which the first members 110 and the second member 120 are laminated is referred to as a Y direction, and the width direction perpendicular to both the Z direction and the Y direction is referred to as an X direction. Furthermore, a surface facing the Y direction is referred to as an upper surface, and a surface facing opposite to the upper surface is referred to as a lower surface.

The probe 10 has a rectangular cross section. The probe 10 has a first side surface 101 and a second side surface 102 that face opposite directions to each other in the thickness direction (the Y direction) and extend in the axial direction. The first side surface 101 is an upper surface of the probe 10, and the second side surface 102 is a lower surface of the probe 10. The probe 10 also has a third side surface 103 and a fourth side surface 104 that face opposite directions to each other in the width direction (the X direction), extend in the axial direction, and connect the first side surface 101 and the second side surface 102. For example, as illustrated in FIG. 1, the cross section of the probe 10 may have a larger size in the width direction than in the thickness direction.

In the cross section illustrated in FIG. 2B, the area ratio of the second member 120 to the first member 110 is relatively higher than in the cross sections illustrated in FIGS. 2A and 2C. Since the second member 120 is a material having a lower hardness than the first member 110, the curved portion 12 having a relatively high area ratio of the second member 120 has a lower rigidity than the tip portion 11 and the base end portion 13 having a relatively low area ratio of the second member 120. Hereinafter, a region in which the area ratio of the second member 120 to the first member 110 in the cross section is relatively higher than in other regions is referred to as a "low-hardness portion". A whole of the curved portion 12 may be the low-hardness portion. The other regions of the probe 10 excluding the low-hardness portion are referred to as "high-hardness portions". The high-hardness portion is a portion having a relatively higher hardness than the low-hardness portion. The tip portion 11 and the base end portion 13 of the probe 10 are the high-hardness portions.

As described above, in the probe 10, the high-hardness portion has a higher rigidity than the low-hardness portion. The area of the cross section is constant from the tip portion 11, which is one end of the probe 10, to the base end portion 13, which is the other end. For this reason, when the probe 10 is elastically deformed, the curved portion 12 is easier to curve than the tip portion 11 and the base end portion 13. Therefore, the probe 10 curves at the curved portion 12 by overdrive without providing a constriction in the curved portion 12 for curving. In this way, the probe 10 has a structure that is easy to curve without providing a constriction that would decrease the allowable current value.

Note that the second member 120 may be a material having a higher electrical conductivity than the first member 110. By using a material having a higher electrical conductivity for the second member 120, the allowable current value of the probe 10 can be further increased. For example, nickel (Ni), a Ni alloy, or the like may be used for the first member 110, and gold (Au), silver (Ag), copper (Cu), or the like may be used for the second member 120.

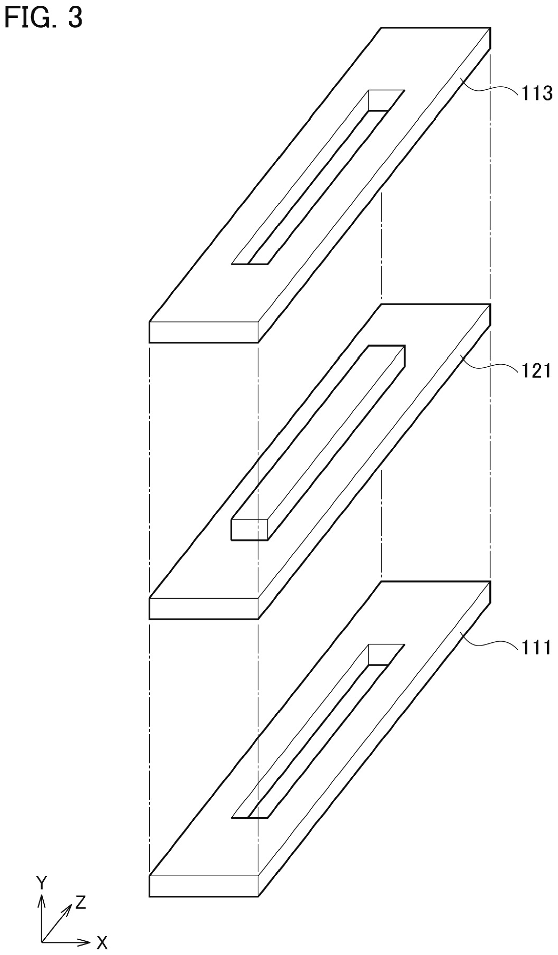

FIG. 3 illustrates the structure of the probe 10 that is disassembled into the first member 110 and the second member 120. The probe 10 illustrated in FIG. 3 has a structure in which a second component 121 made of the second member 120 is interposed between a first component 111 and a third component 113 made of the first member 110 in the Y direction. Protrusions protruding parallel to the Y direction in the curved portion 12 are formed on the upper surface and the lower surface of the second component 121. Through holes into which the protrusions of the second component 121 are fitted are formed in the first component 111 and the third component 113.

In the probe 10 in which the first component 111, the second component 121, and the third component 113 illustrated in FIG. 3 are laminated, the second member 120 is formed in a cross shape in the cross section of the curved portion 12 as illustrated in FIG. 2B. That is, the second member 120 having ends exposed on the third side surface 103 and the fourth side surface 104 includes, in the cross section of the low-hardness portion, an extending portion extending from a central portion to both the first side surface 101 and the second side surface 102. In this way, the first member 110 is divided into two regions in the X direction by the extending portion of the second member 120 extending in the thickness direction. Furthermore, in the cross section of the low-hardness portion, the extending portion of the second member 120 intersects perpendicularly with the first member 110.

On the other hand, in the cross sections of the tip portion 11 and the base end portion 13, which are the high-hardness portions, as illustrated in FIGS. 2A and 2C, the first member 110, the second member 120, and the first member 110, each having a flat plate shape, are laminated in this order. As illustrated in FIG. 3, the probe 10 may be formed such that the first member 110 and the second member 120 each extend continuously throughout a whole of the probe 10 from the tip portion 11 through the curved portion 12 to the base end portion 13.

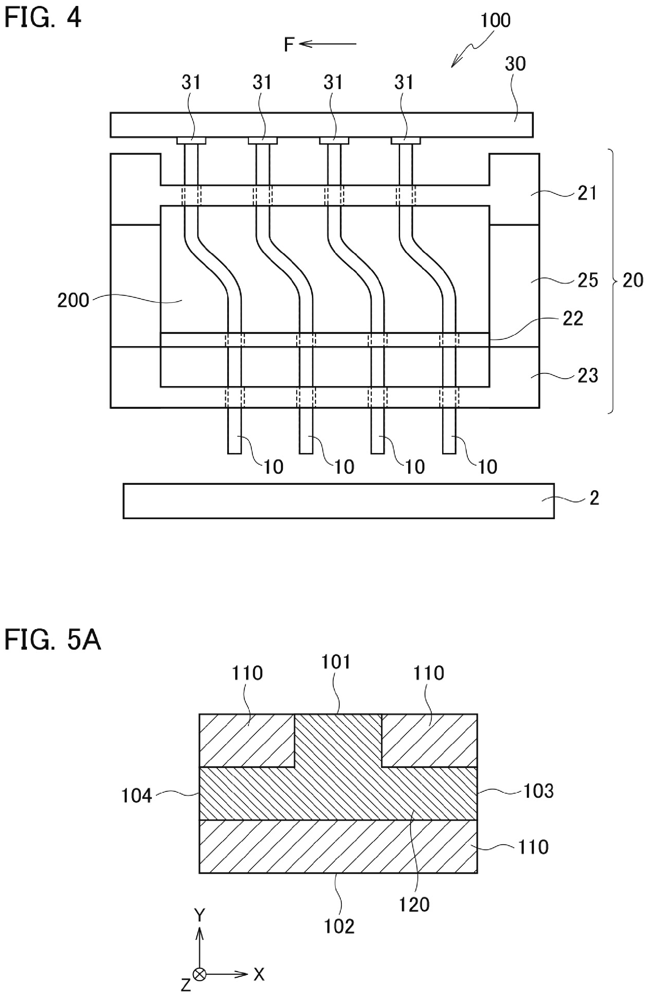

The probe 10 is used in, for example, an electrical connection device 100 illustrated in FIG. 4. In the electrical connection device 100, the probe 10 is held by a probe head 20. The probe head 20 has a configuration in which a first guide plate 21, a second guide plate 22, and a third guide plate 23 are arranged in the axial direction of the probe 10. The first guide plate 21 is also referred to as a top guide plate. The second guide plate 22 is also referred to as a middle guide plate. The third guide plate 23 is also referred to as a bottom guide plate. A hollow region 200 is formed inside the probe head 20 by disposing a spacer 25 between the first guide plate 21 and the second guide plate 22.

As illustrated in FIG. 4, a plurality of probes 10 are held by the probe head 20 by being inserted into guide holes of the first guide plate 21, the second guide plate 22, and the third guide plate 23. The tip portion 11 of the probe 10 passes through the guide holes of the second guide plate 22 and the third guide plate 23. The base end portion 13 of the probe 10 passes through the guide hole of the first guide plate 21. Hereinafter, when the first guide plate 21, the second guide plate 22, and the third guide plate 23 are not individually specified, they are referred to as a guide plate.

The tip portion 11 of the probe 10 comes into contact with an electrode pad (not illustrated) of the inspection target 2 when the inspection target 2 is inspected. The base end portion 13 of the probe 10 comes into contact with a land 31 of a substrate 30 that is laminated on the probe head 20. The land 31 is electrically connected to an inspection device such as an IC tester that is not illustrated.

In the electrical connection device 100 illustrated in FIG. 4, for the guide holes through which a same probe 10 passes, the position of the guide hole of the first guide plate 21, relative to the position of the guide hole of the third guide plate 23, is offset in a direction F parallel to the main surface of the first guide plate 21. Hereinafter, an arrangement in which the positions of the guide holes are offset is referred to as an "offset arrangement". Furthermore, the direction F in which the positions of the guide holes are offset is also referred to as an "offset direction". Due to the offset arrangement, the probe 10 is curved in the hollow region 200 between the first guide plate 21 and the second guide plate 22. That is, in the hollow region 200 between the first guide plate 21 and the second guide plate 22, the probe 10 is in a curved state due to elastic deformation. For example, the offset direction is the thickness direction of the probe 10. The position of the guide hole of the second guide plate 22 and the position of the guide hole of the third guide plate 23 coincide when viewed from the normal direction of the guide plate.

Since the guide holes of the first guide plate 21 and the guide holes of the third guide plate 23 are arranged in an offset arrangement, the probe 10 buckles in the hollow region 200 due to overdrive after the tip portion 11 of the probe 10 comes into contact with the inspection target 2. That is, in a state where the probe 10 is in contact with the inspection target 2 (contact state), the probe 10 is further curved by deflection deformation from the curved shape in a state where the probe 10 is not in contact with the inspection target 2 (non-contact state). As the probe 10 is further curved, the probe 10 comes into contact with the inspection target 2 with a predetermined pressing force. Therefore, due to the offset arrangement, the electrical characteristics of the inspection target 2 can be stably measured using the probe 10. The probe 10 has elasticity to return to the shape before coming into contact with the inspection target 2 when it is in a non-contact state.

The tip portion 11 and the base end portion 13 of the probe 10 are the high-hardness portions. For this reason, even when the probe 10 is curved by overdrive, the tip portion 11 moves linearly along the central axes of the guide holes of the second guide plate 22 and the third guide plate 23. Similarly, the base end portion 13 moves linearly along the central axis of the guide hole of the first guide plate 21. For this reason, damage to the probe 10 which is caused by the side surfaces of the guide holes of the guide plates coming into contact with the probe 10 is suppressed.

As described above, the curved portion 12 of the probe 10 according to the embodiment of the present invention includes the low-hardness portion in which the area ratio of the second member 120 to the first member 110 in the cross section is relatively higher than in other regions. For this reason, the probe 10 has a structure that is easy to curve without decreasing the allowable current value.

Note that, in the cross section of the low-hardness portion, it is preferable that the first member 110 is arranged at the four corners. By arranging the first member 110 having a high hardness at the four corners of the cross section of the probe 10, it is possible to suppress damage to the second member 120 having a low hardness when the probe 10 is held by forceps or the like and transported during and after the manufacturing process of the probe 10.

### <Modified Examples>

In the above description, an example in which the second member 120 is formed in a cross shape in the cross section of the low-hardness portion has been described. However, the arrangement of the first member 110 and the second member 120 in the cross section of the low-hardness portion is not limited to those described above.

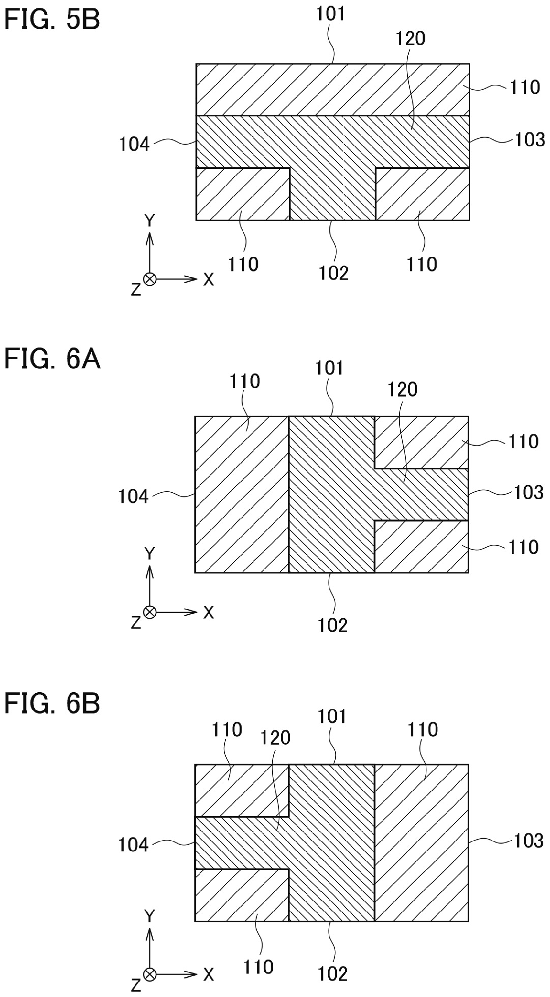

For example, as illustrated in FIGS. 5A and 5B, respectively, the extending portion of the second member 120 may reach either the first side surface 101 or the second side surface 102. In the cross section illustrated in FIG. 5A, the extending portion of the second member 120 reaches only the first side surface 101. In the cross section illustrated in FIG. 5B, the extending portion of the second member 120 reaches only the second side surface 102. In this way, the extending portion of the second member 120 may reach at least one of the first side surface 101 and the second side surface 102.

Furthermore, as illustrated in FIGS. 6A and 6B, respectively, the extending portion of the second member 120 may reach each of the first side surface 101 and the second side surface 102, and the second member 120 may be exposed on at least one of the third side surface 103 and the fourth side surface 104. In the cross section illustrated in FIG. 6A, the second member 120 is exposed only on the third side surface 103. In the cross section illustrated in FIG. 6B, the second member 120 is exposed only on the fourth side surface 104.

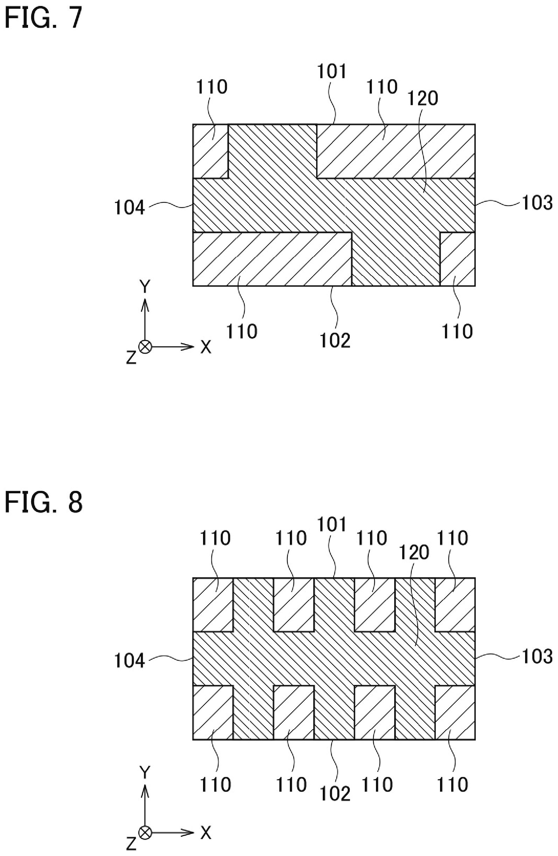

Alternatively, as illustrated in FIG. 7, a first part of the extending portion of the second member 120 reaching the first side surface 101 and a second part of the extending portion reaching the second side surface 102 may be arranged so as not to overlap each other when viewed from the thickness direction. Furthermore, as illustrated in FIG. 8, the cross section of the low-hardness portion may include a plurality of extending portions of the second member 120. In the cross section illustrated in FIG. 8, the first member 110 is divided into a plurality of regions by the plurality of extending portions of the second member 120.

In the above description, an example in which the boundary between the first member 110 and the second member 120 in the cross section is perpendicular to the X direction and the Y direction has been illustrated, but the boundary between the first member 110 and the second member 120 may be oblique to the X direction or the Y direction. Furthermore, although an example in which the second member 120 is exposed on at least one of the third side surface 103 and the fourth side surface 104 has been illustrated, the second member 120 may not be exposed on either the third side surface 103 or the fourth side surface 104. Alternatively, the second member 120 may be divided into a plurality of regions in the cross section.

### (Other Embodiments)

As described above, the present invention has been described by way of the embodiments, but the descriptions and drawings forming part of this disclosure should not be understood as limiting the present invention. From this disclosure, various alternative embodiments, examples, and operational techniques will become apparent to those skilled in the art.

For example, in the above description, the case where the whole of the curved portion 12 is the low-hardness portion has been described, but only a partial region of the curved portion 12 may be the low-hardness portion. This makes it possible to curve a desired region of the probe 10. Furthermore, although the case where a whole of the tip portion 11 and base end portion 13 have a laminated structure of the first member 110 and the second member 120 has been described, a part of each of the tip portion 11 and the base end portion 13 may be constituted only by the first member 110.

Note that when the curved portion of the probe 10 has a lower hardness than other portions, the arrangement of the first member 110 and the second member 120 may be reversed. For example, the cross-shaped Au material region and the other Ni material regions in the structure illustrated in FIG. 2B may be reversed.

As described above, it goes without saying that the present invention includes various embodiments not described above.

### REFERENCE SIGNS LIST

- 10: Probe
- 11: Tip portion
- 12: Curved portion
- 13: Base end portion
- 101: First side surface
- 102: Second side surface
- 103: Third side surface
- 104: Fourth side surface
- 110: First member
- 111: First component
- 113: Third component
- 120: Second member
- 121: Second component

## Claims

1. A probe used for inspecting electrical characteristics of an inspection target, comprising
a structure in which a tip portion to be brought into contact with the inspection target, a curved portion, and a base end portion are sequentially connected in an axial direction, wherein
a first member and a second member having a lower hardness than the first member are mixed in a cross section perpendicular to the axial direction,
the curved portion includes a low-hardness portion in which an area ratio of the second member to the first member in the cross section is relatively higher than in other regions, and
an area of the cross section is constant from the tip portion to the base end portion.

2. The probe according to claim 1, wherein the second member has a higher electrical conductivity than the first member.

3. The probe according to claim 1, wherein the other regions includes the tip portion and the base end portion.

4. The probe according to claim 1, wherein a whole of the curved portion is the low-hardness portion.

5. The probe according to claim 1, wherein
the cross section has a rectangular shape, and
the probe comprises:
a first side surface and a second side surface that face opposite directions to each other in a thickness direction perpendicular to the axial direction and extend in the axial direction; and
a third side surface and a fourth side surface that face opposite directions to each other in a width direction perpendicular to both the axial direction and the thickness direction, extend in the axial direction, and connect the first side surface and the second side surface.

6. The probe according to claim 5, wherein in the cross section of the low-hardness portion, the first member is divided into a plurality of regions by an extending portion of the second member extending in the thickness direction from a central portion.

7. The probe according to claim 6, wherein in the cross section of the low-hardness portion, the extending portion of the second member intersects perpendicularly with the first member.

8. The probe according to claim 6, wherein the extending portion reaches at least one of the first side surface and the second side surface.

9. The probe according to claim 6, wherein the extending portion reaches each of the first side surface and the second side surface, and the second member is exposed on at least one of the third side surface and the fourth side surface.

10. The probe according to claim 6, wherein a first part of extending portion reaching the first side surface and a second part of the extending portion reaching the second side surface do not overlap each other when viewed from the thickness direction.

11. The probe according to claim 6, wherein the cross section of the low-hardness portion includes a plurality of extending portions.

12. The probe according to claim 5, wherein in the cross section of the low-hardness portion, the first member is arranged at four corners.

13. The probe according to claim 5, wherein in the other regions excluding the low-hardness portion, the second member is interposed between first members along the thickness direction over a whole of the width direction.

14. An electrical connection device, comprising:
the probe according to any one of claims 1 to 13;
a probe head that holds the probe; and
a substrate that is laminated on the probe head, wherein
the base end portion of the probe comes into contact with a land disposed on the substrate.

15. The electrical connection device according to claim 14, wherein
the probe head includes a first guide plate and a second guide plate each formed with a guide hole through which the probe passes,
a position of the guide hole of the first guide plate and a position of the guide hole of the second guide plate are offset in a direction parallel to a main surface of the first guide plate, and
the probe is curved in a hollow region between the first guide plate and the second guide plate.
